# EUROPEAN PATENT SPECIFICATION

(11) **EP 2 518 324 B1**
(45) Date of publication and mention of the grant of the patent: **28.09.2016**
(21) Application number: 11008430.8
(22) Date of filing: 20.10.2011
(51) Int. Cl.: F04D 17/04

(54) **Cooling fan**
Kühlgebläse
Ventilateur

(30) Priority: 25.04.2011 TW 100114352
(43) Date of publication of application: 31.10.2012
(73) Proprietor: Sunonwealth Electric Machine Industry Co., Ltd., Kaohsiung, Taiwan R.O.C. (TW)
(72) Inventor: Horng, Alex, Kaohsiung, Taiwan R.O.C. (TW); Chen, Wen-Kuan, Kaoshiung City 80658 Taiwan, R.O.C. Taiwan (TW)
(74) Representative: Köhler, Walter

(56) References cited:
- US-A- 5 997 254
- US-A1- 2005 035 670
- US-A1- 2010 329 886

## Description

### BACKGROUND OF THE INVENTION

### 1. Field of the Invention

The present invention generally relates to a cooling fan and, more particularly, to a cooling fan able to prevent the top of a hub or a blade of a fan wheel from touching the bottom of a lid, such as a fan having an auxiliary shaft between the hub and the lid.

### 2. Description of the Related Art

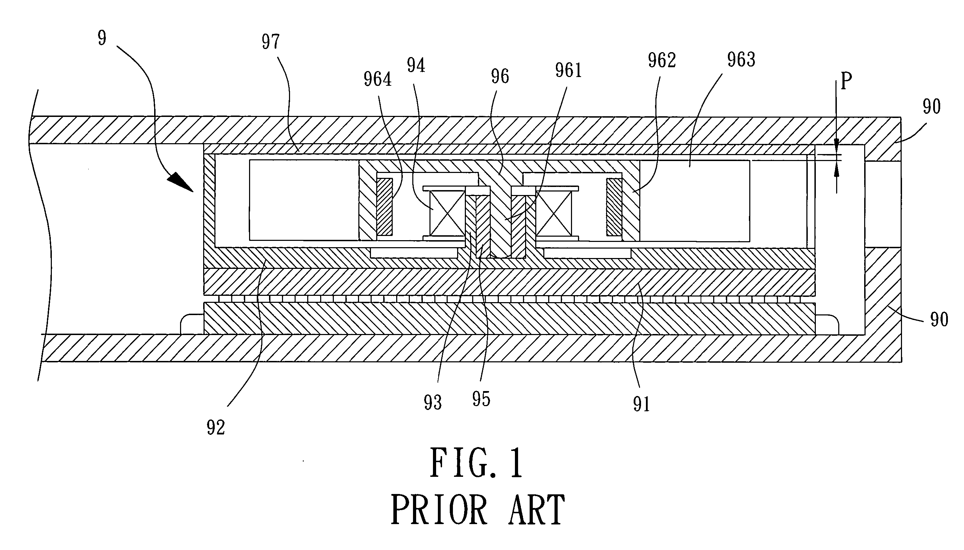

Referring to Fig. 1, a conventional cooling fan 9 received inside a casing 90 to dissipate heat generated by a heat element 91 is shown. The cooling fan 9 has a base 92 where a shaft tube 93 is formed, with an outer periphery of the shaft tube 93 coupled with a stator 94, and with a bearing 95 received inside the shaft tube 93 and rotatably engaged with a shaft 961 of a fan wheel 96. The fan wheel 96 further includes a hub 962 and a plurality of blades 963 radially formed on outer periphery of the hub 962, wherein top edges of the blades 963 are lower than or aligned with the top of the hub 962, and the fan wheel 96 also has a permanent magnet 964 to be driven by the stator 94. There is a gap "P" between the top of the hub 962 of the fan wheel 96 and a lid 97, so that the top of the hub 962 and the top edges of the blades 963 may not touch the lid 97 when the fan wheel 96 is rotated. Furthermore, a part of the shaft 961 of the fan wheel 96 can protrude from the bottom of the bearing 95, and a positioning ring can engage with the part of the shaft 961 protruding form the bottom of the bearing 95, so as to stabilize the axial position of the fan wheel 96 relative to the lid 97 when the fan wheel 96 is driven.

However, when there is only the gap "P" to prevent the top of the hub 962 and the top edges of the blades 963 from touching the lid 97, the fan wheel 96 easily goes upwards across the gap "P" and touches the lid 97 since the magnetic attraction between the permanent magnet 964 and the stator 94 is limited. Besides, although the positioning ring and the protruded part of the shaft 961 can further ensure the separation between the fan wheel 96 and the lid 97, the cooling fan 9 with these additional elements may lead to a complex structure that causes an increased manufacture cost. In light of this, it is desired to improve the conventional cooling fan.

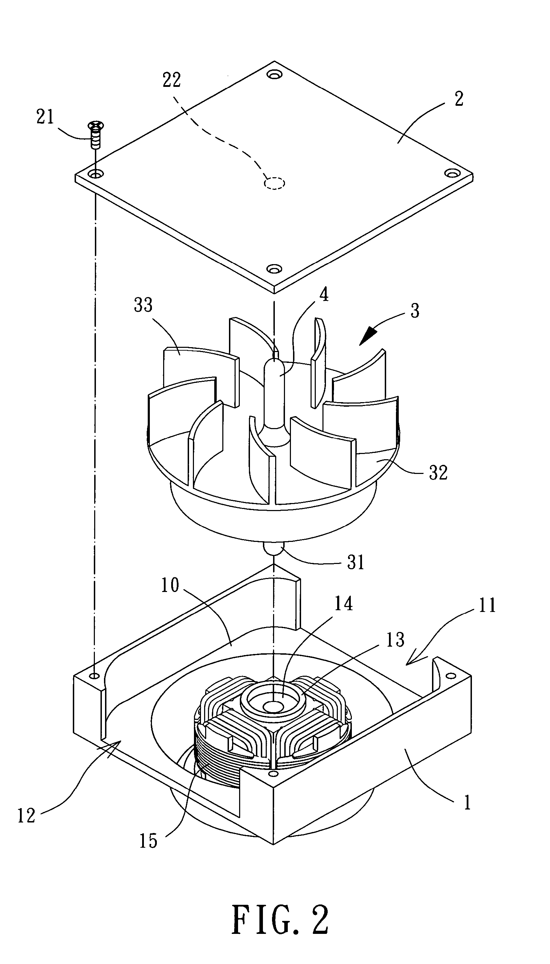

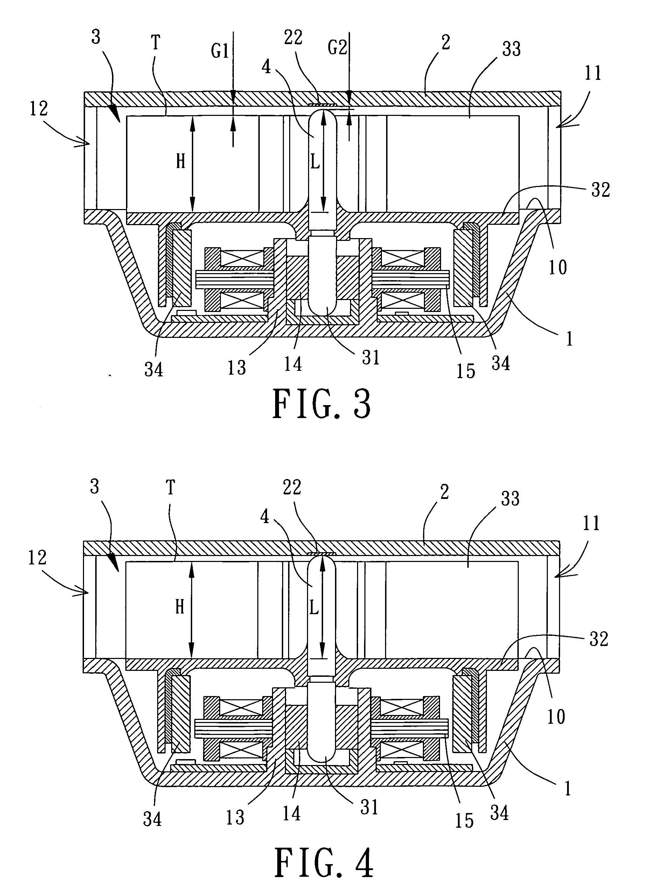

US 2010/0329886 A1 discloses a fan with a cover lid (13), wherein the impeller blades are prevented from touching the cover lid by a central protrusion (30) provided either on the cover lid (fig. 2) or on the impeller hub (fig. 4).

### SUMMARY OF THE INVENTION

It is therefore the primary objective of this invention to provide a cooling fan, wherein a hub and blades of a fan wheel are prevented from touching a lid, so as to lower the operation noise and avoid damage of the cooling fan.

It is therefore another objective of this invention to provide a cooling fan constructed by a simple structure, so as to lower the manufacture cost of the cooling fan.

It is therefore another objective of this invention to provide a cooling fan having an auxiliary shaft assembly sandwiched between a fan wheel and a lid when the fan wheel lifts during operation, so as to enhance the rotation stability of the fan wheel.

The invention discloses a cooling fan comprising a base, a lid, a fan wheel, and an auxiliary shaft assembly. The lid is arranged above the base. The fan wheel has a shaft rotatably coupling with the base and a highest point spaced from the lid by a first gap. The auxiliary shaft assembly is arranged between a top of a hub of the fan wheel and a bottom face of the lid, with a second gap formed between the auxiliary shaft assembly and the top of the hub or between the auxiliary shaft assembly and the bottom face of the lid, wherein the second gap is smaller than the first gap.

Furthermore, the invention discloses a cooling fan comprising a base, a lid, a fan wheel, and an auxiliary shaft assembly. The lid is arranged above the base. The fan wheel has a shaft rotatably coupling with the base and a highest point spaced from the lid by a first gap. The auxiliary shaft assembly is arranged between a top of a hub of the fan wheel and a bottom face of the lid, with the auxiliary shaft assembly having a first auxiliary shaft protruding from the top of the hub and a second auxiliary shaft disposed on the bottom face of lid, with a second gap formed between the first and second auxiliary shafts, wherein the second gap is smaller than the first gap.

The inventive cooling fan is characterized in that a protective plate is mounted on the base above the blades of the fan wheel, with a third gap formed between the highest point (T) and a bottom face of the protective plate, wherein the second gap is smaller than the third gap.

### BRIEF DESCRIPTION OF THE DRAWINGS

The present invention will become more fully understood from the detailed description given hereinafter and the accompanying drawings which are given by way of illustration only, and thus are not limitative of the present invention, and wherein:
Fig. 1 shows a cross-sectional view of a conventional cooling fan.
Fig. 2 shows an exploded and perspective view of a cooling fan according to a first example.
Fig. 3 shows a cross-sectional view of the cooling system of the first example.
Fig. 4 shows a cross-sectional view of the cooling system of the first example in operation.
Fig. 5 shows a cross-sectional view of the cooling system of a second example.
Fig. 6 shows a cross-sectional view of the cooling system of a third example.
Fig. 7 shows a cross-sectional view of the cooling system of a fourth example.
Fig. 8 shows an exploded and perspective view of the cooling system of a first example of practical arrangement of a cooling fan.
Fig. 9 shows a cross-sectional view of the cooling system of the first example of practical arrangement.
Fig. 10 shows an exploded and perspective view of the cooling system of a second example of practical arrangement, which represents an embodiment of the present invention.
Fig. 11 shows a cross-sectional view of the cooling system of the second example of practical arrangement (i.e. of the embodiment of the present invention).

In the various figures of the drawings, the same numerals designate the same or similar parts. Furthermore, when the term "first", "second", "third", "fourth", "inner", "outer" "top", "bottom" and similar terms are used hereinafter, it should be understood that these terms refer only to the structure shown in the drawings as it would appear to a person viewing the drawings, and are utilized only to facilitate describing the invention.

### DETAILED DESCRIPTION OF THE INVENTION

Referring to Figs. 2 and 3, a cooling fan with a base 1, a lid 2, a fan wheel 3 and an auxiliary shaft assembly 4 is shown according to a first example.

The base 1 is adapted to support the fan wheel 3. The lid 2 is arranged on a side of the fan wheel 3 opposite to the base 1 so as to protect the fan wheel 3. The fan wheel 3 is able to rotate relatively to the base 1 and lid 2. The auxiliary shaft assembly 4 is disposed between the lid 2 and the fan wheel 3 to prevent the fan wheel 3 from touching the lid 2.

The base 1 has an air channel 10 forming at least one first opening 11 and at least one second opening 12. Specifically, if the present cooling fan is an axial fan, the at least one first opening 11 and at least one second opening 12 are formed on two axial sides of the base 1, with the two axial sides spaced out in an axial direction of the fan wheel 3. If the present cooling fan is a centrifugal fan, the at least one first opening 11 and at least one second opening 12 are formed on at least one of lateral sides of the base 1, with the lateral sides surrounding the fan wheel 3 in a circumferential direction of the fan wheel 3. If the present cooling fan is a mixed fan, the at least one first opening 11 is formed on one of the two axial sides of the base 1, and the at least one second opening 12 is form on at least one of the lateral sides of the base 1. Moreover, the base 1 can further provide a shaft tube 13 coupling with a connecting member 14, such as a bearing, and a stator 15.

The lid 2 is arranged above the base 1, and specifically mounted on the top of the base 1 through a positioning member 21, with the positioning member 21 being a screw. However, the way to position the lid 2 on the base 1 can also be another conventional way such as elastic engagement or adhesion. Moreover, the bottom of the lid 2 can form a wear-resisting member 22 facing the auxiliary shaft assembly 4 for a free end of the auxiliary shaft assembly 4 to abut against, so as to enhance the rotation stability of the fan wheel 3.

The fan wheel 3 has a shaft 31 rotatably received in the shaft tube 13 of the base 1, while the connecting member 14 may connect between the shaft 31 and the shaft tube 13 for improving rotation smoothness of the shaft 31. The fan wheel 3 further includes a hub 32 where a plurality of blades 33 are mounted, and the blades 33 can extend by a protruding height "H" in an axial direction of the fan wheel 3 from the top of the hub 32. A permanent magnet 34 is disposed on an inner periphery of the hub 32 and faces the stator 15 of the base 1, so that the stator 15 can drive the fan wheel 3 to rotate and drive the air in the air channel 10 of the base 1. Therefore, an air flow can be induced in a direction from the at least one first opening 11 to the at least one second opening 12, or from the at least one second opening 12 to the at least one first opening 11. A highest point "T" of the fan wheel 3 is defined, with a first gap "G1" formed between the highest point "T" and the lid 2; that is, the highest point "T" is spaced from the lid 2 by the first gap "G1." Specifically, when the blades 33 axially extend by the protruding height "H," the highest point "T" is at a top edge of each the blade 33; however, the highest point "T" is at the top of the hub 32 if the blades 33 are laterally and radially formed on the hub 32 only and do not axially extend over the top of the hub 32. Moreover, the cooling fan shown in Figs. 2 and 3 is completed by an outer rotor motor, with the stator 15 mounted on the shaft tube 13 and the permanent magnet 34 facing the stator 15 inwards; however, the cooling fan of the invention can also be completed by a conventional inner rotor motor, with the permanent magnet 34 mounted on the shaft 31 and facing the stator 15 outwards.

The auxiliary shaft assembly 4 is arranged between the top of the hub 32 of the fan wheel 3 and the bottom face of the lid 2. The auxiliary shaft assembly 4 can be a single rod connected with the top of the hub 32 of the fan wheel 3 or the bottom face of the lid 2, or can also be two separate rods respectively connected with the top of the hub 32 of the fan wheel 3 and the bottom face of the lid 2. In this example, the auxiliary shaft assembly 4 is a single rod connected with the top of the hub 32 of the fan wheel 3, with the single rod integrally formed by the shaft 31. Preferably, the single rod serving as the auxiliary shaft assembly 4 is disposed on a rotational axis of the fan wheel 3 and has a predetermined length "L" larger than the said protruding height "H." Specifically, a second gap "G2" is defined between the bottom face of the lid 2 and a free end of the single rod serving as the auxiliary shaft assembly 4, and the second gap "G2" is smaller than the said first gap "G1." Besides, when the second gap "G2" is decreased to zero, the free end of the single rod abuts against the bottom of the lid 2, particularly against the wear-resisting member 22 of the lid 2, so that the auxiliary shaft assembly 4 may enhance the rotation stability of the fan wheel 3. Furthermore, the free end of the single rod serving as the auxiliary shaft assembly 4 is preferably in a round shape or a taper shape if it is designed to abut against the bottom of the lid 2, so as to lower the friction between the signal rod and the lid 2 or the wear-resisting member 22.

Referring to Fig. 4, in operation of the presented cooling fan, when the fan wheel 3 is shifted towards the lid 2, only the auxiliary shaft assembly 4 is allowed to touch the bottom face of the lid 2 since the second gap "G2" is smaller than the first gap "G1" as well as the predetermined length "L" is larger than the protruding height "H." Therefore, the highest point "T" of the fan wheel 3, such as top edges of the blades 33 of the fan wheel 3 in this example, is surely prevented from touching the bottom face of the lid 2. Specifically, the additional wear-resisting member 22 for the auxiliary shaft assembly 4 shifted along with the fan wheel 3 to abut against can thus enhance the rotation stability of the fan wheel 3.

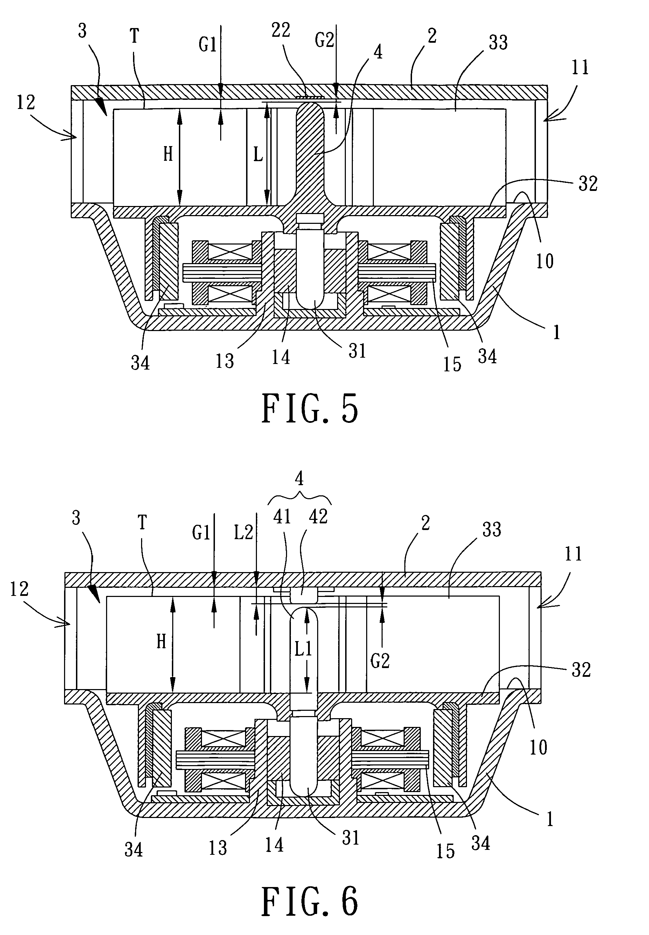

Referring to Fig. 5, a second example of a cooling fan is shown. In this example, the auxiliary shaft assembly 4 is in the form of a single rod integrally formed on the fan wheel 3, and is preferably made of the same material of the fan wheel 3 and formed on the top of the hub 32. Similarly, the second gap "G2" between the bottom face of the lid 2 and a free end of the single rod serving as the auxiliary shaft assembly 4 is smaller than the first gap "G1" between the highest point "T" and the bottom face of the lid 2, or the predetermined length "L" is larger than the protruding height "H." Accordingly, the highest point "T" of the fan wheel 3, such as top edges of the blades 33 of the fan wheel 3 in this embodiment, is surely prevented from touching the bottom of the lid 2.

Referring to Fig. 6, a third example of a cooling fan is shown. In comparison with the elements of the first example, the major difference between the third and first examples lies in that the auxiliary shaft assembly 4 includes two separate parts in this example, that is, a first auxiliary shaft 41 and a second auxiliary shaft 42. Specifically, the first auxiliary shaft 41 protrudes from the top of the hub 32, with the first auxiliary shaft 41 having a length "L1" and preferably integrally formed by the shaft 31. The second auxiliary shaft 42 with a length "L2" is disposed on the bottom face of lid 2 and extends towards the first auxiliary shaft 41, so that the lengths "L1," "L2" jointly define a predetermined length "L" of the auxiliary shaft assembly 4. Furthermore, in this example, a gap between the first and second auxiliary shafts 41, 42 is defined as the second gap "G2" since the second auxiliary shaft 42 connects with the lid 2 and there is no separation between the auxiliary shaft assembly 4 and the lid 2 in this example.

Similarly, the predetermined length "L" is larger than the protruding height "H," or the second gap "G2" between the first and second auxiliary shafts 41, 42 is smaller than the first gap "G1" between the highest point "T" and the bottom face of the lid 2. Both of the first and second auxiliary shafts 41, 42 are preferably disposed on the rotational axis of the fan wheel 3, with at least one of two free ends of the auxiliary shafts 41, 42, which face each other oppositely, in a round shape or a taper shape to lower the friction between the first and second auxiliary shafts 41, 42 when these auxiliary shafts 41, 42 contact with each other. Therefore, the highest point "T" of the fan wheel 3, such as top edges of the blades 33 of the fan wheel 3 in this example, is impossible to touch the bottom of the lid 2 since the touched first and second auxiliary shafts 41, 42 can prevent any further axial collision between the blades 33 and the lid 2.

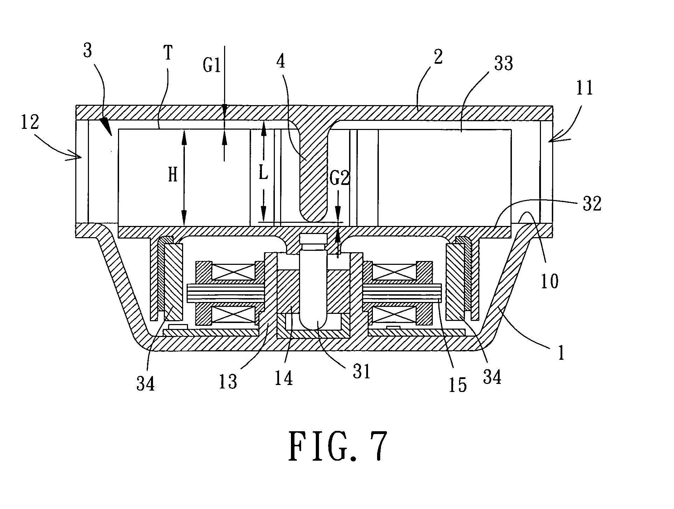

Referring to Fig. 7, a fourth example of a cooling fan is shown. In this example, the auxiliary shaft assembly 4 is in the form of a single rod integrally formed on the lid 2, and is preferably made of the same material of the lid 2 and formed on the bottom face of the lid 2. Besides, a gap between the single rod serving as the auxiliary shaft assembly 4 and the hub 32 of the fan wheel 3 is defined as the second gap "G2" since the single rod connects with the lid 2 and there is no separation between the auxiliary shaft assembly 4 and the lid 2 in this embodiment. Similarly, the second gap "G2" between the auxiliary shaft assembly 4 and the fan wheel 3 is smaller than the first gap "G1" between the highest point "T" and the bottom face of the lid 2, or the predetermined length "L" is larger than the protruding height "H." Therefore, the highest point "T" of the fan wheel 3, such as top edges of the blades 33 of the fan wheel 3 in this example, is impossible to touch the bottom of the lid 2 since the auxiliary shaft assembly 4 and fan wheel 3, which may abut against each other in operation, can prevent any further axial collision between the blades 33 and the lid 2.

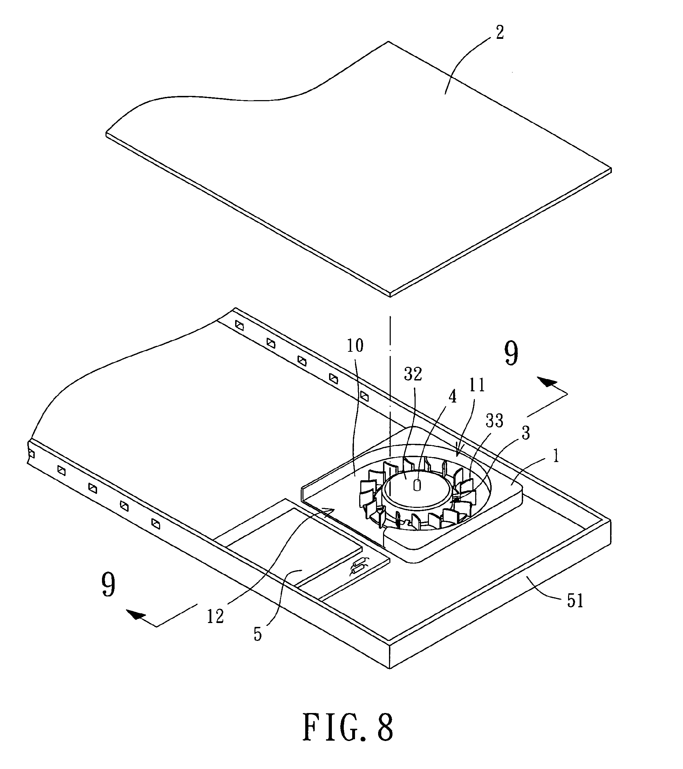

Please refer to Figs. 8-10 which illustrate two examples of practical arrangement of cooling fans.

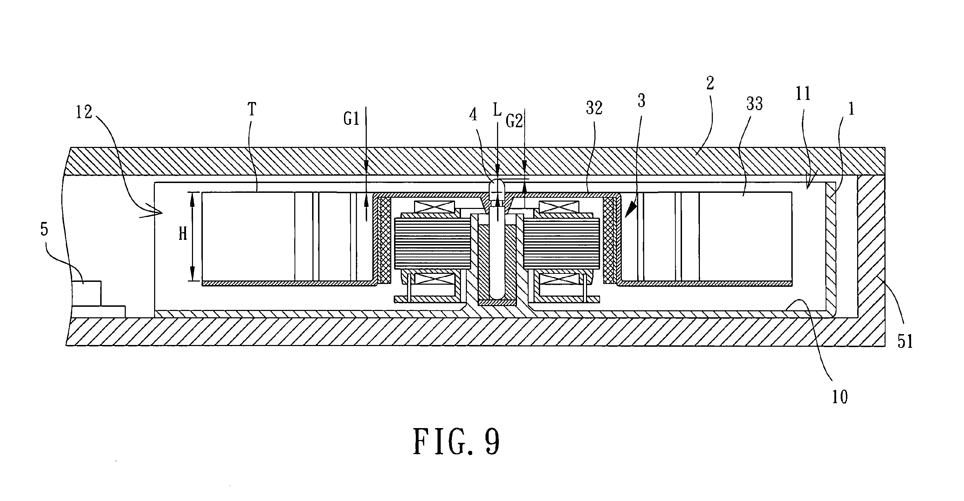

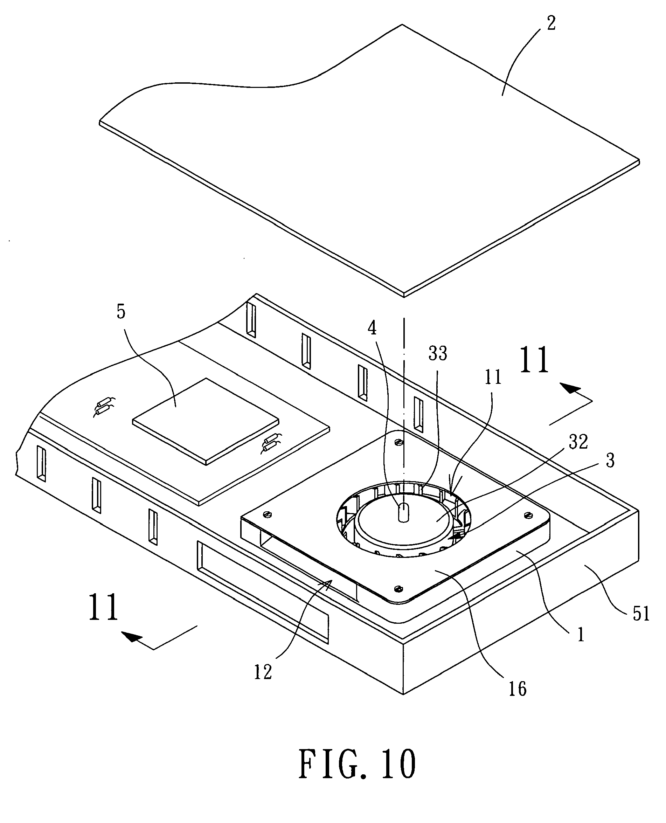

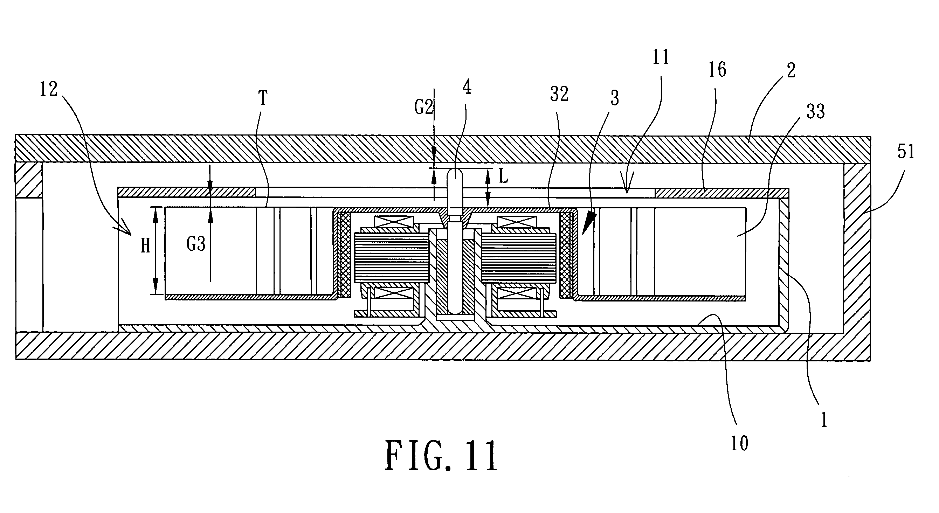

The fan wheel 3 is rotatably coupled with the base 1 for the blades 33 to drive the air to flow from the at least one first opening 11 to the at least one second opening 12 in the air channel 10. The base 1, fan wheel 3, auxiliary shaft assembly 4 and a heat element 5 that heats the surrounding air are received inside a housing 51, and the lid 2 is a cover plate of the housing 51. In the first example, as shown in Figs. 8 and 9, the at least one second opening 12 of the base 1 is adjacent to the heat element 5 for the driven air flow outputted by the at least one second opening 12 to blow away the hot air around the heat element 5. In the second example, which represents an embodiment of the present invention, as shown in Figs. 10 and 11, the cooling fan draws the hot air around the heat element 5 via the at least one first opening 11 of the base 1 and expels the hot air via the at least one second opening 12 of the base 1. Specifically, in the second example, a protective plate 16 is arranged on the base 1 by any conventional way for combination such as elastic engagement or adhesion, with the protective plate 16 defining the first opening 11 and arranged above the blades 33 of the fan wheel 3.

Moreover, with reference to Fig. 11, since the protective plate 16 is added and the fan wheel 3 directly faces the protective plate 16, a gap between the highest point "T" and the bottom face of the protective plate 16 is defined as a third gap "G3," with the second gap "G2" between the auxiliary shaft assembly 4 and the lid 2 smaller than the third gap "G3" between the highest point "T" and the bottom face of the protective plate 16, or with the predetermined length "L" larger than the protruding height "H." Accordingly, the highest point "T" of the fan wheel 3, such as top edges of the blades 33 of the fan wheel 3, is surely prevented from touching the bottom of the protective plate 16.

In summary, the cooling fan of the present invention can surely prevent the fan wheel 3 from touching the lid 2 based on the arrangement of the auxiliary shaft assembly 4 between the fan wheel 3 and the lid 2, so as to lower the operation noise and avoid damage of the cooling fan. Besides, the arrangement of the above elements is simple and may not further complicate the structure of the cooling fan, so as to lower the manufacture cost thereof. Furthermore, the auxiliary shaft assembly 4 can enhance the rotation stability of the fan wheel 3 even through the fan wheel 3 lifts during operation.

Although the invention has been described in detail with reference to its presently preferable embodiment, it will be understood by one of ordinary skill in the art that various modifications can be made without departing from the scope of the invention, as set forth in the appended claims.

## Claims

1. A cooling fan, wherein the words "above", "highest", "top" and "bottom" refer to a position of the fan in which the rotation axis of the fan wheel is vertical, the fan comprising:
a base (1);
a lid (2) arranged above the base (1);
a fan wheel (3) having a shaft (31) rotatably coupling with the base (1) and a highest point (T) spaced from the lid (2) by a first gap (G1); and
an auxiliary shaft assembly (4) arranged between a top of a hub (32) of the fan wheel (3) and a bottom face of the lid (2), wherein the second gap (G2) is formed between the auxiliary shaft assembly (4) and the top of the hub (32) or between the auxiliary shaft assembly (4) and the bottom face of the lid (2) and wherein the second gap (G2) is smaller than the first gap (G1)
**characterized in**
**that** a protective plate (16) is mounted on the base (1) above blades (33) of the fan wheel (3), with a third gap (G3) formed between the highest point (T) and a bottom face of the protective plate (16), wherein the second gap (G2) is smaller than the third gap (G3).

2. The cooling fan as claimed in claim 1,
wherein the auxiliary shaft assembly (4) has a first auxiliary shaft (41) protruding from the top of the hub (32) and a second auxiliary shaft (42) disposed on the bottom face of lid (2), with the second gap (G2) formed between the first and second auxiliary shafts (41, 42).

3. The cooling fan as claimed in claim 1,
wherein blades (33) of the fan wheel (3) extend by a protruding height (H) in an axial direction of the fan wheel (3) from the top of the hub (32), and the auxiliary shaft assembly (4) has a predetermined length (L) larger than the protruding height (H).

4. The cooling fan as claimed in claim 1,
wherein the auxiliary shaft assembly (4) is a single rod connected with the top of the hub (32) of the fan wheel (3).

5. The cooling fan as claimed in claim 1,
wherein the auxiliary shaft assembly (4) is integrally formed on the fan wheel (3).

6. The cooling fan as claimed in claim 1,
wherein the auxiliary shaft assembly (4) is a single rod arranged on the bottom face of the lid (2).

7. The cooling fan as claimed in claim 1,
wherein the auxiliary shaft assembly (4) is disposed on a rotational axis of the fan wheel (3).

8. The cooling fan as claimed in claim 1,
wherein the auxiliary shaft assembly (4) is integrally formed by the shaft (31).

9. The cooling fan as claimed in claim 1,
wherein a free end of the auxiliary shaft assembly (4) is in a circular shape or a taper shape.

10. The cooling fan as claimed in claim 4,
wherein the bottom face of the lid (2) forms a wear-resisting member (22) facing the auxiliary shaft assembly (4).

11. The cooling fan as claimed in claim 2,
wherein the first auxiliary shaft (41) is integrally formed on the fan wheel (3).

12. The cooling fan as claimed in claim 2,
wherein the first auxiliary shaft (41) is integrally formed by the shaft (31).

13. The cooling fan as claimed in claim 2,
wherein at least one of two free ends of the first and second auxiliary shafts (41, 42) is in a circular shape or a taper shape.

## Patentansprüche

1. Kühlgebläse, bei dem sich die Wörter "über", "am höchsten", "Oberseite" und "Unterseite" auf eine Position des Gebläses beziehen, bei der die Drehachse des Gebläserads vertikal ist, wobei das Gebläse Folgendes umfasst:
eine Basis (1);
einen Deckel (2), der über der Basis (1) angeordnet ist;
ein Gebläserad (3), das eine Welle (31) aufweist, die mit der Basis (1) drehbar koppelt, und einen höchsten Punkt (T) besitzt, der über einen ersten Spalt (G1) von dem Deckel (2) beabstandet ist; und
eine zusätzliche Wellenanordnung (4), die zwischen einer Oberseite einer Nabe (32) des Gebläserads (3) und einer Unterseite des Deckels (2) angeordnet ist, wobei der zweite Spalt (G2) zwischen der zusätzlichen Wellenanordnung (4) und der Oberseite der Nabe (32) oder zwischen der zusätzlichen Wellenanordnung (4) und der Unterseite des Deckels (2) ausgebildet ist, und wobei der zweite Spalt (G2) kleiner als der erste Spalt (G1) ist,
**dadurch gekennzeichnet,**
**dass** eine Schutzplatte (16) an der Basis (1) über Schaufeln (33) des Gebläserads (3) angebracht ist, wobei ein dritter Spalt (G3) zwischen dem höchsten Punkt (T) und einer Unterseite der Schutzplatte (16) ausgebildet ist, wobei der zweite Spalt (G2) kleiner als der dritte Spalt (G3) ist.

2. Kühlgebläse nach Anspruch 1,
wobei die zusätzliche Wellenanordnung (4) eine erste zusätzliche Welle (41), die von der Oberseite der Nabe (32) vorsteht, und eine zweite zusätzliche Welle (42), die an der Unterseite des Deckels (2) angeordnet ist, aufweist, wobei der zweite Spalt (G2) zwischen der ersten und der zweiten zusätzlichen Welle (41, 42) ausgebildet ist.

3. Kühlgebläse nach Anspruch 1,
wobei sich Schaufeln (33) des Gebläserads (3) mit einer vorstehenden Höhe (H) in einer axialen Richtung des Gebläserads (3) von der Oberseite der Nabe (32) erstrecken, und wobei die zusätzliche Wellenanordnung (4) eine vorher festgelegte Länge (L) aufweist, die größer als die vorstehende Höhe (H) ist.

4. Kühlgebläse nach Anspruch 1,
wobei die zusätzliche Wellenanordnung (4) ein einzelner Stab ist, der mit der Oberseite der Nabe (32) des Gebläserads (3) verbunden ist.

5. Kühlgebläse nach Anspruch 1,
wobei die zusätzliche Wellenanordnung (4) an dem Gebläserad (3) einteilig ausgebildet ist.

6. Kühlgebläse nach Anspruch 1,
wobei die zusätzliche Wellenanordnung (4) ein einzelner Stab ist, der an der Unterseite des Deckels (2) angeordnet ist.

7. Kühlgebläse nach Anspruch 1,
wobei die zusätzliche Wellenanordnung (4) an einer Drehachse des Gebläserads (3) angeordnet ist.

8. Kühlgebläse nach Anspruch 1,
wobei die zusätzliche Wellenanordnung (4) mit der Welle (31) einteilig ausgebildet ist.

9. Kühlgebläse nach Anspruch 1,
wobei ein freies Ende der zusätzlichen Wellenanordnung (4) eine kreisförmige Form oder eine konisch zulaufende Form aufweist.

10. Kühlgebläse nach Anspruch 4,
wobei die Unterseite des Deckels (2) ein verschleißfestes Element (22) bildet, das der zusätzlichen Wellenanordnung (4) zugewandt ist.

11. Kühlgebläse nach Anspruch 2,
wobei die erste zusätzliche Welle (41) an dem Gebläserad (3) einteilig ausgebildet ist.

12. Kühlgebläse nach Anspruch 2,
wobei die erste zusätzliche Welle (41) mit der Welle (31) einteilig ausgebildet ist.

13. Kühlgebläse nach Anspruch 2,
wobei wenigstens eines der zwei freien Enden der ersten und der zweiten zusätzlichen Welle (41, 42) eine kreisförmige Form oder eine konisch zulaufende Form aufweist.

## Revendications

1. Ventilateur de refroidissement, dans lequel les termes « au-dessus », « le plus haut », « supérieur » et « inférieur » concernent une position du ventilateur dans laquelle l'axe de rotation de la roue de ventilateur est verticale, le ventilateur comprenant :
une base (1) ;
un couvercle (2) agencé au-dessus de la base (1) ;
une roue de ventilateur (3) ayant un arbre (31) se couplant en rotation avec la base (1) et un point le plus haut (T) espacé du couvercle (2) par un premier espace (G1) ; et
un ensemble d'arbre auxiliaire (4) agencé entre une partie supérieure d'un moyeu (32) de la roue de ventilateur (3) et une face inférieure du couvercle (2), dans lequel le deuxième espace (G2) est formé entre l'ensemble d'arbre auxiliaire (4) et la partie supérieure du moyeu (32) ou entre l'ensemble d'arbre auxiliaire (4) et la face inférieure du couvercle (2) et dans lequel le deuxième espace (G2) est plus petit que le premier espace (G1),
**caractérisé en ce qu'**une plaque de protection (16) est montée sur la base (1) au-dessus des pales (33) de la roue de ventilateur (3), avec un troisième espace (G3) formé entre le point le plus haut (T) et une face inférieure de la plaque de protection (16), dans lequel le deuxième espace (G2) est plus petit que le troisième espace (G3).

2. Ventilateur de refroidissement selon la revendication 1,
dans lequel l'ensemble d'arbre auxiliaire (4) a un premier arbre auxiliaire (41) faisant saillie à partir de la partie supérieure du moyeu (32) et un second arbre auxiliaire (42) disposé sur la face inférieure du couvercle (2), avec le deuxième espace (G2) formé entre les premier et second arbres auxiliaires (41, 42).

3. Ventilateur de refroidissement selon la revendication 1,
dans lequel les pales (33) de la roue de ventilateur (3) s'étendent par une hauteur en saillie (H) dans une direction axiale de la roue de ventilateur (3) à partir de la partie supérieure du moyeu (32), et l'ensemble d'arbre auxiliaire (4) a une longueur (L) prédéterminée plus grande que la hauteur en saillie (H).

4. Ventilateur de refroidissement selon la revendication 1,
dans lequel l'ensemble d'arbre auxiliaire (4) est une tige unique raccordée avec la partie supérieure du moyeu (32) de la roue de ventilateur (3).

5. Ventilateur de refroidissement selon la revendication 1,
dans lequel l'ensemble d'arbre auxiliaire (4) est formé de manière solidaire sur la roue de ventilateur (3).

6. Ventilateur de refroidissement selon la revendication 1,
dans lequel l'ensemble d'arbre auxiliaire (4) est une tige unique agencée sur la face inférieure du couvercle (2).

7. Ventilateur de refroidissement selon la revendication 1,
dans lequel l'ensemble d'arbre auxiliaire (4) est disposé sur un axe de rotation de la roue de ventilateur (3).

8. Ventilateur de refroidissement selon la revendication 1,
dans lequel l'ensemble d'arbre auxiliaire (4) est formé de manière solidaire par l'arbre (31).

9. Ventilateur de refroidissement selon la revendication 1,
dans lequel une extrémité libre de l'ensemble d'arbre auxiliaire (4) se présente sous une forme circulaire ou une forme progressivement rétrécie.

10. Ventilateur de refroidissement selon la revendication 4,
dans lequel la face inférieure du couvercle (2) forme un élément résistant à l'usure (22) faisant face à l'ensemble d'arbre auxiliaire (4).

11. Ventilateur de refroidissement selon la revendication 2,
dans lequel le premier arbre auxiliaire (41) est formé de manière solidaire sur la roue de ventilateur (3).

12. Ventilateur de refroidissement selon la revendication 2,
dans lequel le premier arbre auxiliaire (41) est formé de manière solidaire par l'arbre (31).

13. Ventilateur de refroidissement selon la revendication 2,
dans lequel au moins l'une des deux extrémités libres des premier et second arbres auxiliaires (41, 42) se présente sous une forme circulaire ou une forme progressivement rétrécie.
